# EUROPEAN PATENT APPLICATION

(11) **EP 4 651 674 A2**
(43) Date of publication of application: **19.11.2025**
(21) Application number: 25176231.6
(22) Date of filing: 13.05.2025
(51) Int. Cl.: H10D 84/01, H10D 84/83, H10D 84/85, H10D 88/00, H01L 25/065

(54) **CFET ARCHITECTURES WITH METAL TRACE ROUTING BETWEEN STACKED TRANSISTOR DEVICES**

(30) Priority: 14.05.2024 US 202418664072
(71) Applicant: INTEL Corporation, Santa Clara, CA 95054 (US)
(72) Inventor: OSTERMAYR, Martin, 85457 Woerth (DE); LUTZ, Walther, 85435 Erding (DE); STAHL, Joachim, 92714 Pleystein (DE); THOMAS, Nicole, Portland 97209 (US); RADOSAVLJEVIC, Marko, Portland 97229 (US)
(74) Representative: 2SPL Patentanwälte PartG mbB

(57) **Abstract**

In one embodiment, a complementary field effect transistor (CFET) device includes one or more metallization layers between stacked transistors.

## Description

### BACKGROUND

Transistors continue to be scaled down, facilitating higher integration schemes and higher functionalities of integrated circuit device dies. One potential advancement is the introduction of CFET (complementary field-effect transistor) devices, which appear to be attractive device architectures for beyond 1nm logic devices. CFET devices include

### BRIEF DESCRIPTION OF THE DRAWINGS

FIGS. 1A-1D are perspective views of example planar, FinFET, gate-all-around (GAA), and stacked gate-all-around transistors.
FIGS. 2A-2C illustrate cross-sectional views of example CFET devices according to the present disclosure.
FIGS. 3A-3D illustrate perspective views of example CFET devices with stacked GAA transistor devices according to the present disclosure.
FIG. 4 illustrates an example sequential process for manufacturing a CFET device in accordance with embodiments herein.
FIG. 5 illustrates another example sequential process for manufacturing a CFET device in accordance with embodiments herein.
FIG. 6 illustrates an example device that includes a CFET device in accordance with embodiments herein.
FIGS. 7A-7C illustrate example diagrams of memory cells implemented with different types of transistors.
FIG. 8 is a top view of a wafer and dies that may be included in embodiments disclosed herein.
FIG. 9 is a cross-sectional side view of an integrated circuit device that may be included in embodiments herein.
FIG. 10 is a cross-sectional side view of an integrated circuit device assembly that may include embodiments disclosed herein.
FIG. 11 is a block diagram of an example electrical device that may include embodiments disclosed herein.

### DETAILED DESCRIPTION

In embodiments herein, a complementary field effect transistor (CFET) device includes vertically stacked n-type and p-type transistors and one or more metallization layers with traces routed between the n-type and p-type transistors of the CFET device. The CFET devices can include any suitable type of underlying transistor device technology, including planar transistors, FinFET, or Gate All Around (GAA) technologies (e.g., nanowire or nanosheet technologies). CFET devices according to the present disclosure can be manufactured either monolithically, e.g., where the transistor device stack is fabricated on one wafer, or by a sequential process, e.g., where a bottom transistor device and top transistor device (or portions thereof) are fabricated separately and then bonded together (e.g., wafer-to-wafer bonding).

CFET architectures can provide scaling improvements over current architectures. For example, FinFET architectures may be limited in lateral scaling due to sidewall damage and can be limited to vertical scaling. In addition, GAA architectures may be width and pitch dependent, with their workfunction and threshold voltages being fixed per sheet in the nanosheet stack. CFET architectures, on the other hand, can allow for improved scaling by also using the z-direction; however, such architectures may still be limited by metal routing and interconnect limitations.

Accordingly, aspects of the present disclosure implement metal trace routing between the n-type and p-type devices in CFET stacks. Such routing may be in addition to front-side metallization (FSM) layers or back-side metallization (BSM) layers, e.g., as a second metallization level in a case of no BSM layers or as a third metallization level where a device includes both FSM and BSM layers. The metal traces according to the present disclosure can be used for any suitable purpose, including, for example, standard cell design, memory bitcell designs, low jitter clock and noise sensitive signals, or signal lines (global or local).

Embodiments herein can provide a number of advantages over typical CFET stacks. For example, devices according to the present disclosure can provide further area saving over current CFET architectures and allow for extension of Moore's Law. The routing resources between the transistor levels can be used for routing between std. cell channels or for making inverter gate/drain connections. Additionally, traces according to the present disclosure can be used to improve heat transport away from the active the transistor devices of the CFET stack, which can produce large amounts of heat and potentially limit performance or functionality. For example, in some embodiments, a metal-plate (or another material with high thermal conductivity) can be implemented between the devices in the CFET stack as a thermal vent. Some embodiments may include routing lines that aid in isolating the devices of the stack. For example, some embodiments may include an airgap (a cavity filled with air) or other high dielectric material between the devices of a CFET stack, which can help prevent parasitic losses/charge leakage between the devices of the stack, while some embodiments may include ground and VDD lines that can act as a decoupling capacitor between the devices. Furthermore, routing between the devices of a CFET stack can allow for the implementation of high sensitive signal routing, improving circuit design for standard cells and memory bitcells, preventing cross talk for noise sensitive signals or clock signals. In addition, in some cases, it may be possible to "free" metal lines and overcome limitations in current standard cell routing channels or memory bitlines/wordlines, allowing for compressed standard cells, SRAM and memory bitcells.

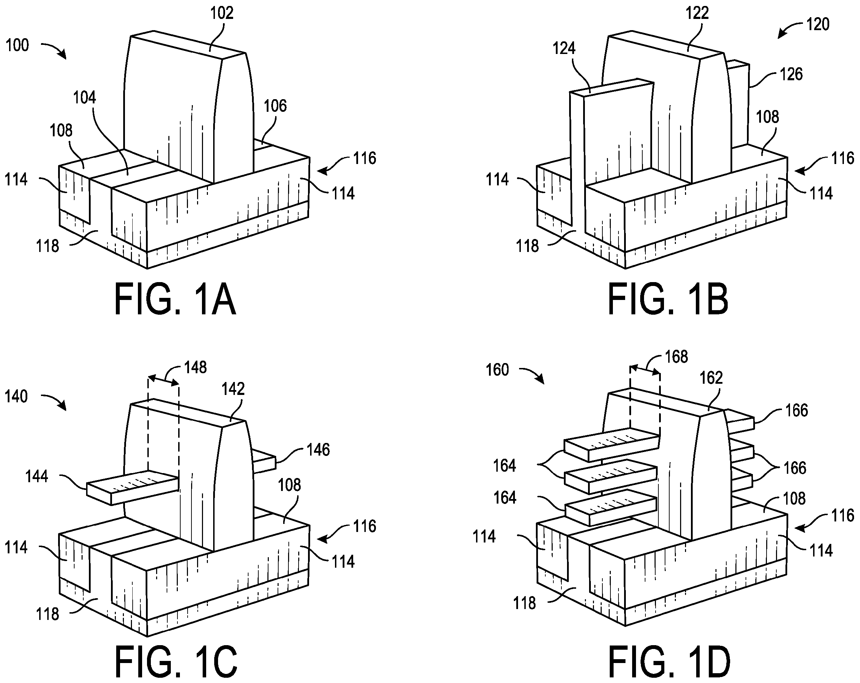

FIGS. 1A-1D are simplified perspective views of example planar, FinFET, gate-all-around, and stacked gate-all-around transistors. Any of the example transistors shown (including their variants) can be included in embodiments of the present disclosure. The transistors illustrated in FIGS. 1A-1D are formed on a substrate 116 having a surface 108. Isolation regions 114 separate the source and drain regions of the transistors from other transistors and from a bulk region 118 of the substrate 116.

FIG. 1A is a perspective view of an example planar transistor 100 comprising a gate 102 that controls current flow between a source region 104 and a drain region 106. The transistor 100 is planar in that the source region 104 and the drain region 106 are planar with respect to the substrate surface 108.

FIG. 1B is a perspective view of an example FinFET transistor 120 comprising a gate 122 that controls current flow between a source region 124 and a drain region 126. The transistor 120 is non-planar in that the source region 124 and the drain region 126 comprise "fins" that extend upwards from the substrate surface. As the gate 122 encompasses three sides of the semiconductor fin that extends from the source region 124 to the drain region 126, the transistor 120 can be considered a tri-gate transistor. FIG. 1B illustrates one S/D fin extending through the gate 122, but multiple S/D fins can extend through the gate of a FinFET transistor.

FIG. 1C is a perspective view of a gate-all-around (GAA) transistor 140 comprising a gate 142 that controls current flow between a source region 144 and a drain region 146. The transistor 140 is non-planar in that the source region 144 and the drain region 146 are elevated from the substrate surface.

FIG. 1D is a perspective view of a GAA transistor 160 comprising a gate 162 that controls current flow between multiple elevated source regions 164 and multiple elevated drain regions 166. The transistor 160 is a stacked GAA transistor as the gate controls the flow of current between multiple elevated S/D regions stacked on top of each other. The transistors 140 and 160 are considered gate-all-around transistors as the gates encompass all sides of the semiconductor portions that extends from the source regions to the drain regions, forming the transistor channels. The transistors 140 and 160 can alternatively be referred to as nanowire, nanosheet, or nanoribbon transistors depending on the width (e.g., widths 148 and 168 of transistors 140 and 160, respectively) or shape of the semiconductor portions extending through the gate. Although the transistor 160 includes three semiconductor portions (nanowires, nanosheets, or nanoribbons) extending through the gate 162, other embodiments may include two or more than three semiconductor portions.

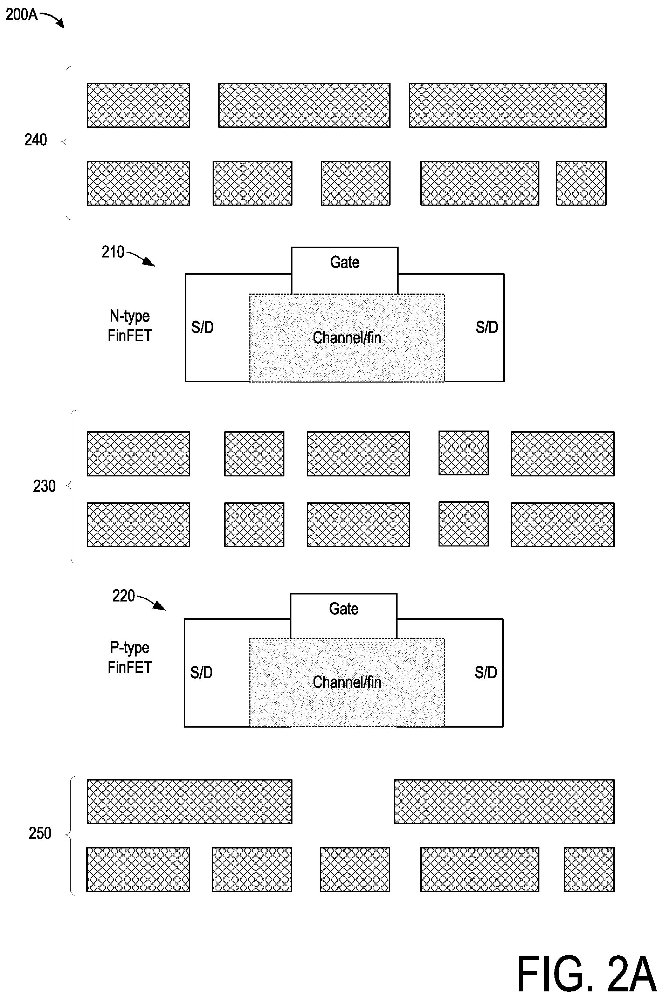

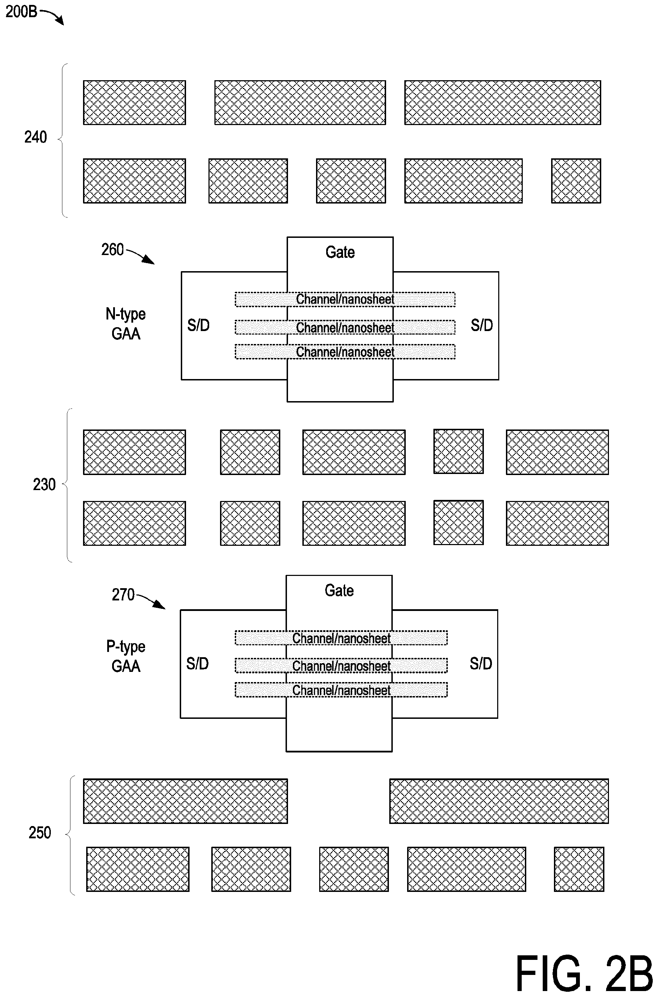

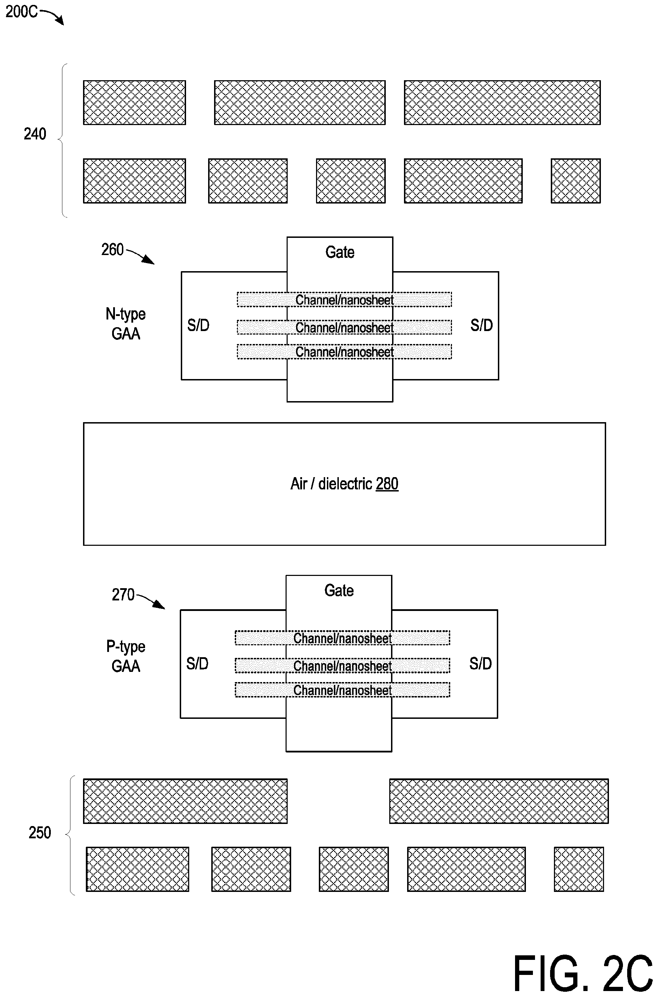

FIGS. 2A-2C illustrate cross-sectional views of example CFET devices 200A-C according to the present disclosure. In particular, FIG. 2A illustrates an example CFET device 200A with stacked FinFET devices 210, 220 and metallization layers 230 between the stacked FinFET devices 210, 220, FIG. 2B illustrates an example CFET device 200B with stacked GAA devices 260, 270 and metallization layers 230 between the stacked FinFET devices 210, 220, and FIG. 2C illustrates an example CFET device 200C with stacked GAA devices 260, 270 and a layer 280 of air or another gas (e.g., in a cavity within the CFET device) or another high-k dielectric material between the devices 260, 270. Although the CFET devices 260, 270 are illustrated as having three channel/nanosheet regions, other embodiments may include one, two, or more than three channel/nanosheet regions.

Although not illustrated, it will be understood that the CFET devices shown in FIGS. 2A-2C include dielectric material(s) between each of the layers or transistor devices shown. Where the layer 280 includes a dielectric material other than air/gas, the dielectric material may have a higher dielectric constant than the other dielectric material used in the device (e.g., the dielectric material used between respective metallization layers or between the transistors and the metallization layers). In addition, although not shown in FIGS. 2A-2C, it will be understood that various portions of the transistors (e.g., the gate or source/drain regions) and/or metallization layers can be interconnected by vias as appropriate (e.g., as needed per an integrated circuit design).

The devices shown in FIGS. 2A-2C may be fabricated using a monolithic process, e.g., where the device is fabricated on one wafer, or by a sequential process, e.g., by manufacturing portions of the CFET device separately and then bonding the portions together. In each example, the CFET device includes an n-type transistor device above a p-type transistor device in the CFET device stack; however, other embodiments may include a p-type transistor device above an n-type transistor device in the stack. Further, while two metallization layers are shown in each of the front side metallization layers (e.g., 240), back side metallization layers (e.g., 250), and middle metallization layers (e.g., 230), other embodiments can include any suitable number of metallization layers in each of the metallization layer stacks (230, 240, or 250), e.g., one, three, four, five, or more metallization layers each. Moreover, the traces in any of the metallization layers illustrated can be of different width, thickness, etc. than shown. Some embodiments may also not include backside metallization layers 250.

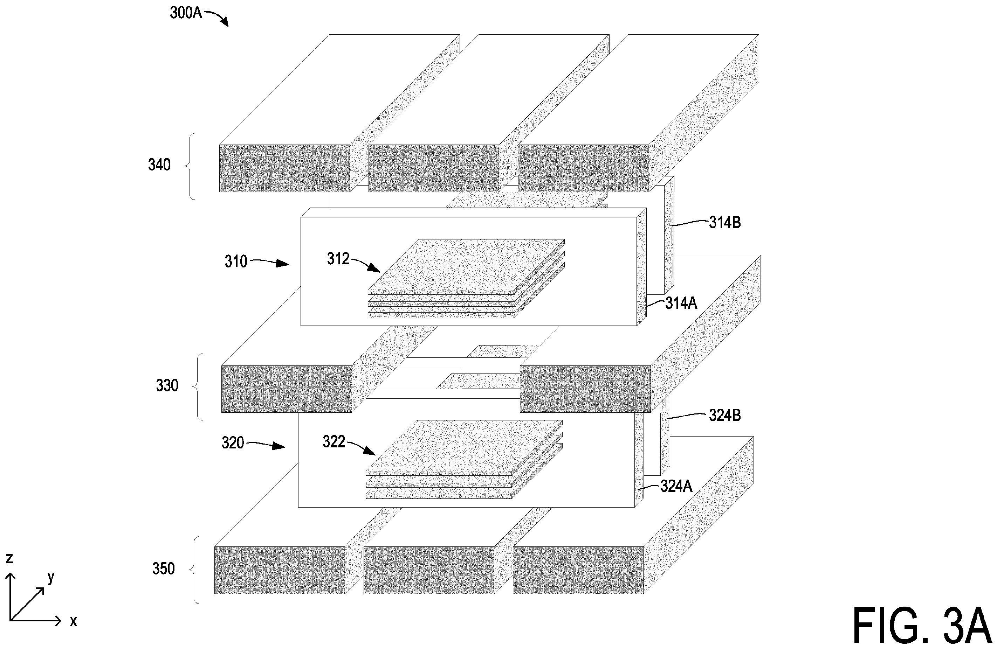

FIGS. 3A-3D illustrate perspective views of example CFET devices 300A-D with stacked GAA transistor devices according to the present disclosure. In each example shown, the CFET device includes a first set of nanosheet GAA transistors 310 stacked above (in the z-direction) a second set of nanosheet GAA transistors 320, with one or more middle metallization layers 330 between the transistors (in the z-direction). Although the example transistors are illustrated as having three nanosheet regions (312, 322), other embodiments may include one, two, or more than three channel/nanosheet regions. Further, other embodiments may implement FinFET or other types of transistors instead of GAA transistors. The middle metallization layer(s) 330 may be used for any suitable purpose, including one or more of signal routing, clock signal routing, power delivery routing, electrical isolation between the top and bottom transistors of the stack (e.g., by implementing a decoupling capacitor between the top and bottom transistors), or thermal regulation (e.g., to carry heat away from the transistors). In some embodiments, an air gap or high-k dielectric layer can be implemented in the space where the middle metallization layer(s) 330 are located, e.g., as shown in FIG. 2C. The air gap/high-k dielectric can be in lieu of or in addition to metallization layers in the area between the transistors.

Each CFET device also includes a front side metallization layer 340 above the first transistors 310 in the z-direction and a back side metallization layer 350 below the second transistors 320 in the z-direction. As shown, the traces within the middle metallization layer(s) 330 may be routed in the x-direction or the y-direction, and the traces can be of any suitable thickness or width. The transistors 310, 320 are formed from nanosheets 312, 322 and gate materials 314A-B, 324 A-B around the nanosheets as shown. It will be understood that the transistors also include source/drain regions (not shown) on either side of the gate materials 314A-B, 324A-B (e.g., as shown in FIGS. 2A-2C). In addition, although not shown in FIGS. 3A-3D, it will be understood that various portions of the transistors (e.g., the gate regions) and/or metallization layers can be interconnected by vias as appropriate (e.g., as needed per an integrated circuit design).

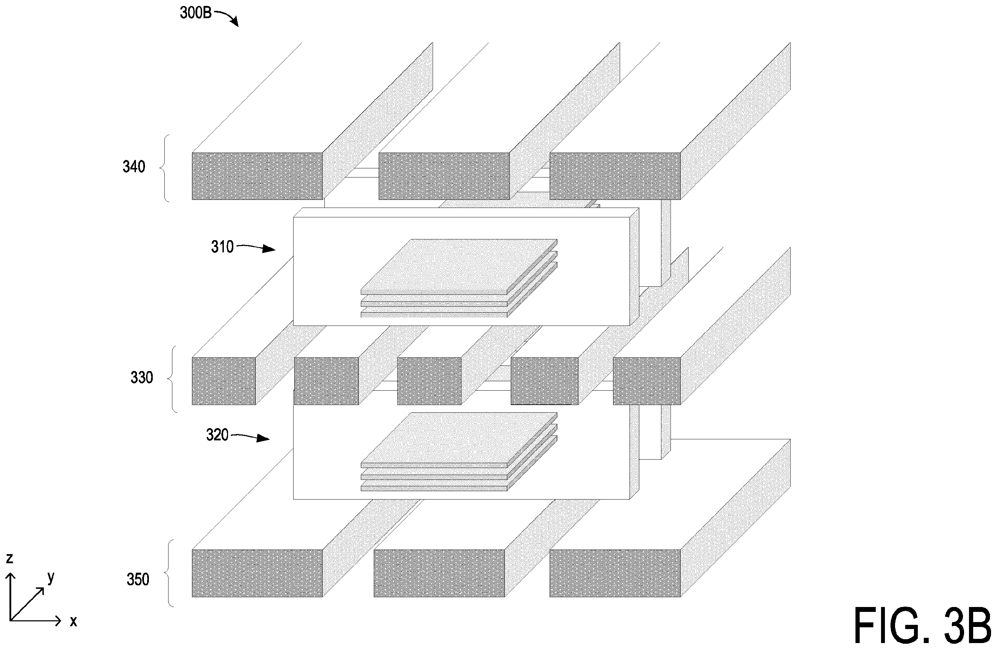

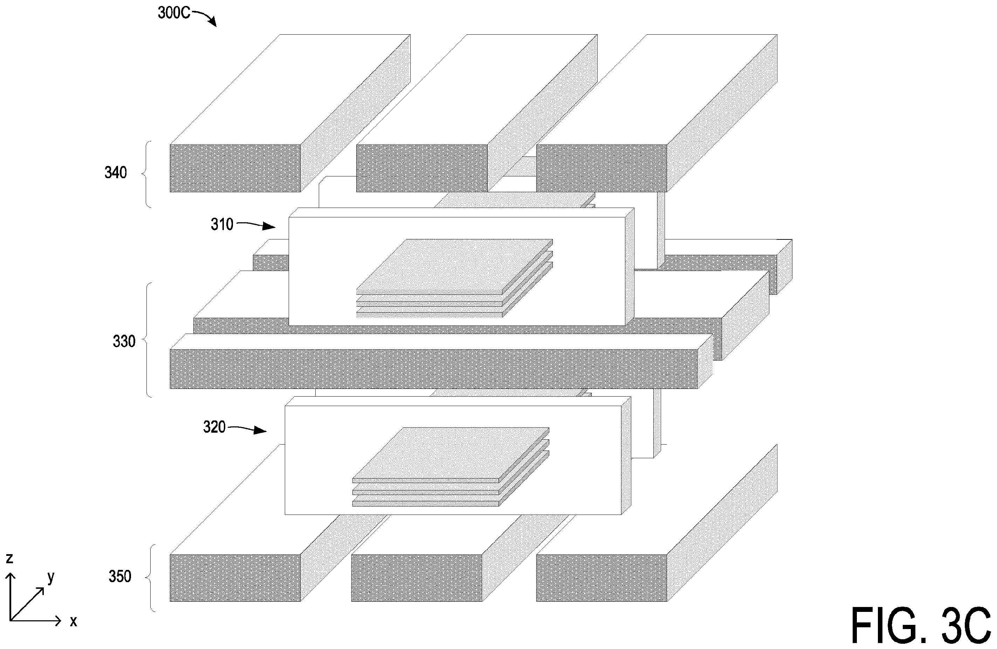

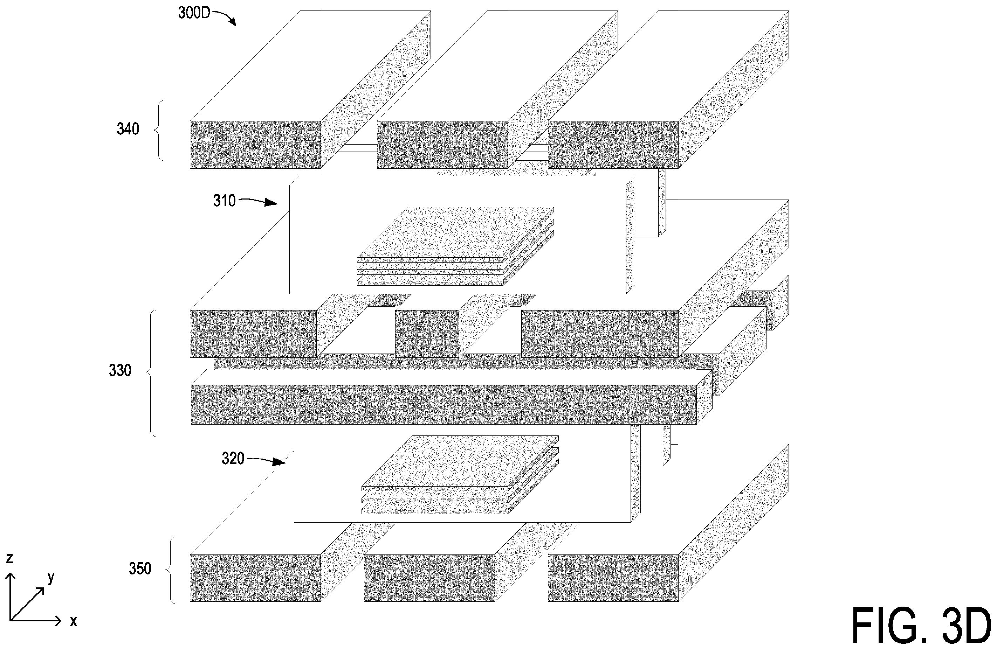

Referring to FIG. 3A, the CFET device 300A includes a single metallization layer 330 between the first transistors 310 and the second transistors 320. Each of the two traces shown within the metallization layer 330 are similar in width to the traces in the metallization layers 340, 350. The CFET device 300B of FIG. 3B similarly includes a single metallization layer 330 between the first transistors 310 and the second transistors 320, but the traces shown within the metallization layer 330 have shorter widths relative to the traces in the metallization layers 340, 350. The CFET device 300C of FIG. 3C also includes a single metallization layer 330 between the first transistors 310 and the second transistors 320, but the traces are routed in the x-direction (as opposed to in the y-direction as in FIGS. 3A-3B). The CFET device 300D of FIG. 3D includes two metallization layers 330 between the first transistors 310 and the second transistors 320, with the top layer of the layers 330 being routed in the y-direction and the bottom layer of the layers 330 being routed in the x-direction. Additional layers may be included within the middle metallization layers 330 than those shown. In addition, the routing may be in any suitable direction and the traces may be of any suitable width. In some embodiments, the routing within a single layer can be in a combination of directions (e.g., some traces in the x-direction and some in the y-direction).

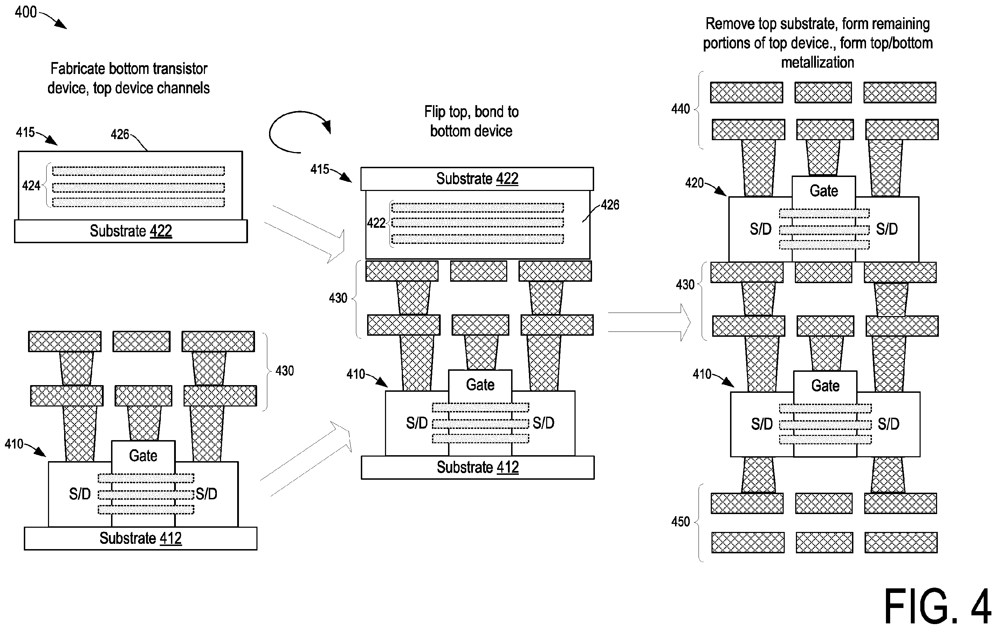

FIG. 4 illustrates an example sequential process 400 for manufacturing a CFET device in accordance with embodiments herein. The example process may include additional or different operations, and the operations may be performed in the order shown or in another order. In some cases, one or more of the operations shown are implemented as processes that include multiple operations, sub-processes, or other types of routines. In some cases, operations can be combined, performed in another order, performed in parallel, iterated, or otherwise repeated or performed another manner. In the example shown, the CFET device includes stacked nanosheet GAA transistors; however, other embodiments may include FinFET or other types of transistor devices.

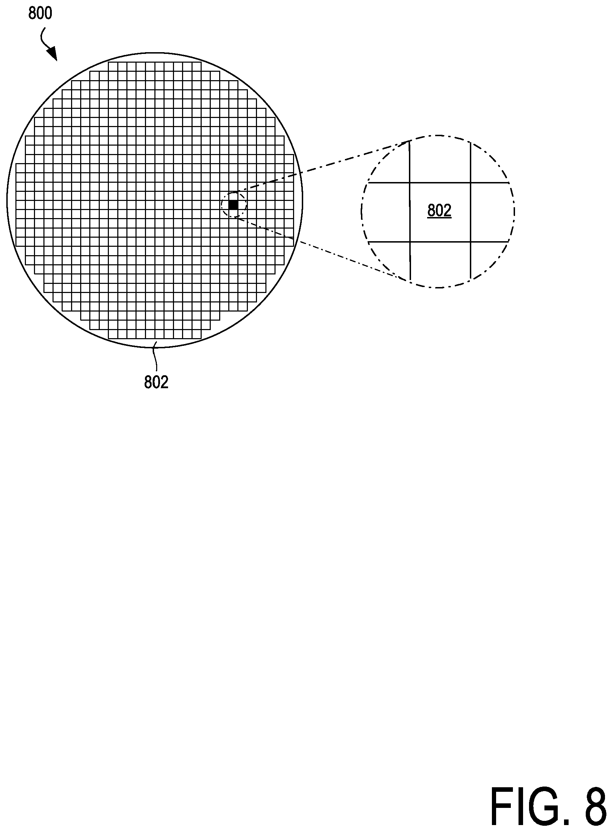

In the example process 400, a first nanosheet transistor 410 is fabricated on a substrate 412. Although shown as a single transistor 410, it will be understood the transistor 410 may be one of multiple transistors formed in a similar manner to 410 on a wafer (e.g., 800 of FIG. 8). The transistor 410 can be fabricated in any suitable manner, but the fabrication process may include one or more of the following operations: SiGe/Si epitaxy for nanosheet formation, shallow trench isolation (STI) formation, nanosheet reveal, dummy gate formation, spacer formation, source/drain region epitaxy, channel release, and gate formation. In addition, metallization layers 430 are formed above the first transistor 410. In the example shown, two metallization layers are formed on the transistor 410; however, other embodiments may form a single metallization layer on the transistor 410, while other embodiments may form more than two metallization layers on the transistor 410. Although shown as being performed later on in the process 400, backside metallization layers 450 can also be formed in this portion of the process 400.

Separately, nanosheets 424 for a second transistor (420) are formed on a substrate 422, within a dielectric material 426. Similar to the example above, it will be understood the nanosheets 424 may be one of multiple sets of nanosheets formed in a similar manner on a wafer (e.g., 800 of FIG. 8). The apparatus 415 with the nanosheets 424 (e.g., a wafer similar to 800) can then be flipped over (rotated approximately 180 degrees) and bonded to the apparatus (e.g. a wafer) with the transistor 410. The substrate 422 can then be removed, e.g., via polishing (e.g., chemical mechanical polishing) and remaining portions of the second transistor 420 can be formed, including the source/drain and gate regions as shown on the right side of FIG. 4. Then metallization layers 440 can be formed above the second transistor 420 as shown. In the example shown, two metallization layers are formed in 440; however, other embodiments may form a single metallization layer on the transistor 420, while other embodiments may form more than two metallization layers 440.

In addition, in some embodiments, backside metallization layers 450 can be formed below the transistor 420, e.g., by flipping the bonded transistors and forming the layers 450, removing the substrate 412 (e.g., via chemical mechanical polishing or other techniques), and forming the metallization layers 450 in a similar manner to the layers 440. The backside metallization layers 450 may be used for power delivery to the CFET device in certain embodiments, e.g., as opposed to, or in addition to, power delivery from the front side metallization layers 440, which can free up more of the traces in the metallization layers 440 for signal routing or for other purposes.

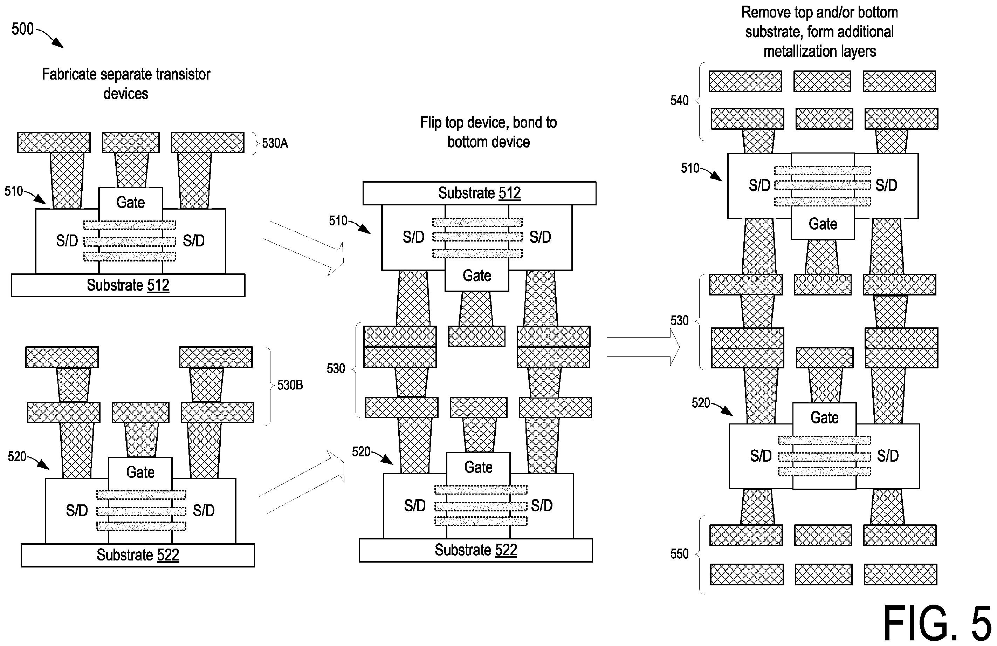

FIG. 5 illustrates another example sequential process 500 for manufacturing a CFET device in accordance with embodiments herein. The example process may include additional or different operations, and the operations may be performed in the order shown or in another order. In some cases, one or more of the operations shown are implemented as processes that include multiple operations, sub-processes, or other types of routines. In some cases, operations can be combined, performed in another order, performed in parallel, iterated, or otherwise repeated or performed another manner. In the example shown, the CFET device includes stacked nanosheet GAA transistors; however, other embodiments may include FinFET or other types of transistor devices.

In the example process 500, a first nanosheet transistor 410 and second nanosheet transistor 420 are fabricated separately, on substrates 412, 422, respectively. Although shown as single transistors, it will be understood the transistors may be one of multiple transistors formed on a wafer (e.g., 800 of FIG. 8). The transistors can be fabricated in any suitable manner, but the fabrication process may include one or more of the following operations: SiGe/Si epitaxy for nanosheet formation, shallow trench isolation (STI) formation, nanosheet reveal, dummy gate formation, spacer formation, source/drain region epitaxy, channel release, and gate formation. In addition, metallization layers 530A, 530B are formed above the first transistor 510 and second transistor 520, respectively. While certain numbers of metallization layers 530 are shown, other embodiments may form other numbers of metallization layers on one or both of the transistors 510, 520. For example, some embodiments may form metallization layers on only one of the transistors 510 or 520, while other embodiments may form multiple metallization layers 530 on each of the transistors 510, 520.

The wafer (e.g., a wafer similar to 800) with the transistor(s) 510 can then be flipped over and bonded to the wafer with the transistor(s) 520. This can include a metal-to-metal bonding between the metallization layers 530A, 530B, as shown. The substrate 512 can then be removed, e.g., via polishing (e.g., chemical mechanical polishing) and metallization layers 540 can be formed above the transistor(s) 510 as shown. In the example shown, two metallization layers are formed in 540; however, other embodiments may form a single metallization layer on the transistor 510, while other embodiments may form more than two metallization layers 540. In addition, in some embodiments, backside metallization layers 550 can be formed below the transistor(s) 520. This can be done as shown, e.g., by flipping the bonded transistors and forming the layers 450, removing the substrate 522 (e.g., via chemical mechanical polishing or other techniques), and forming the metallization layers 550 in a similar manner to the layers 540. In other embodiments, the backside metallization layers 550 may be formed prior to bonding the top and bottom wafers. The backside metallization layers 550 may be used for power delivery to the CFET device in certain embodiments, e.g., as opposed to, or in addition to, power delivery from the front side metallization layers 540.

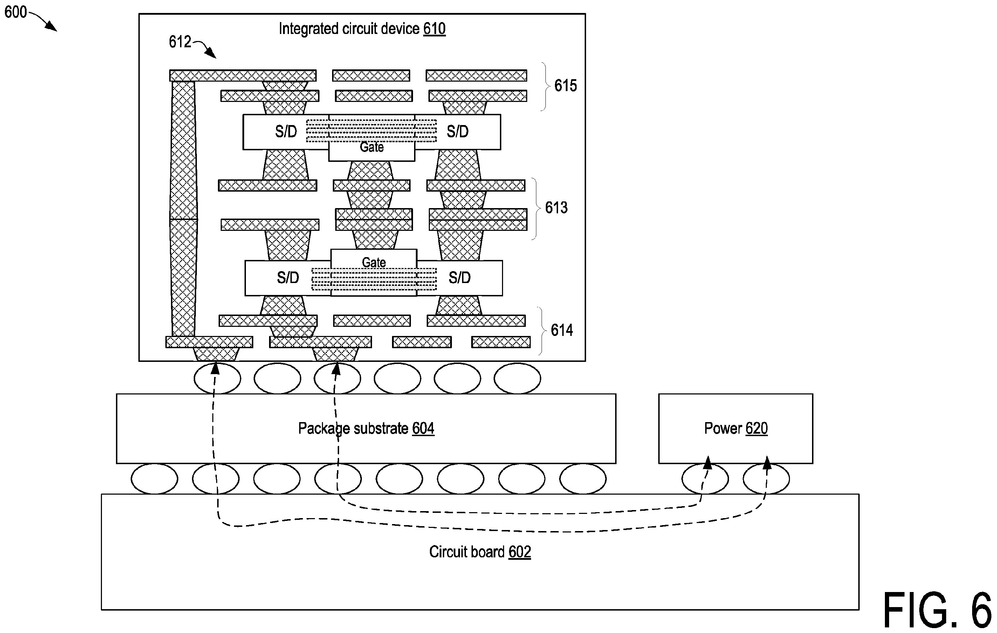

FIG. 6 illustrates an example system 600 that includes a CFET device in accordance with embodiments herein. The example system 600 includes a circuit board 602, which may be implemented as a motherboard or main board of a computer system in some embodiments. The example system 600 also includes a package substrate 604 with an integrated circuit device 610 attached to the package substrate 604. The device 610 includes a CFET device 612 with middle metallization layers between its stacked transistors, as shown. Although the device 610 is shown with one CFET device 612, the device 610 may include any suitable number of CFET devices implemented similar to the CFET device 612.

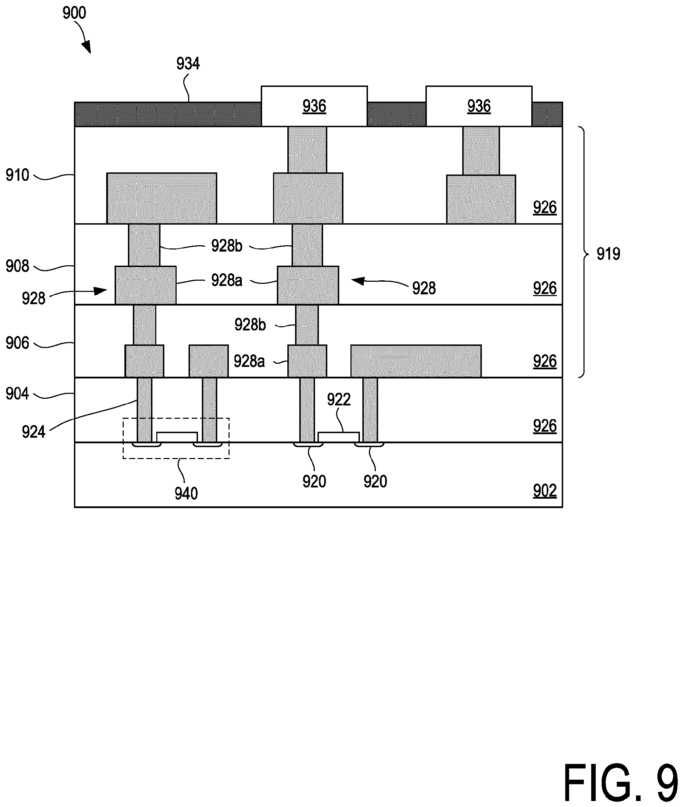

In some embodiments, the device 610 may be a packaged or unpacked integrated circuit product that includes one or more integrated circuit dies (e.g., the die 802 of FIG. 8, the integrated circuit device 900 of FIG. 9) and/or one or more other suitable components. The device 610 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the device 610 can comprise one or more additional active or passive devices such as capacitors, decoupling capacitors, resistors, inductors, fuses, diodes, transformers, sensors, electrostatic discharge (ESD) devices, and memory devices. In addition to comprising one or more processor units, the device 610 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". The package substrate 604 may provide electrical connections between the device 610 and the circuit board 602.

As shown, the CFET device includes front side metallization layers 614, backside metallization layers 615, and middle metallization layers 613 between the top and bottom transistors of the CFET device 612. The various layers can be used for any suitable purpose, including signal routing, power delivery (from the power supply circuitry 620 coupled to the circuit board 602), or for other purposes. In the example shown, backside metallization layers 615 are used at least partially for power delivery and the middle metallization layers 613 are used at least partially for interconnections between the transistors of the CFET device 612.

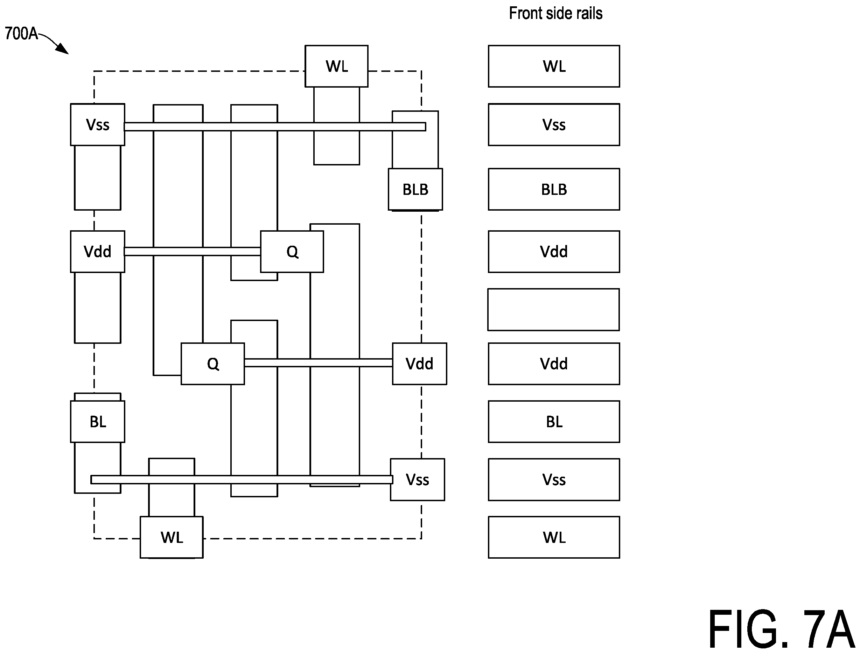

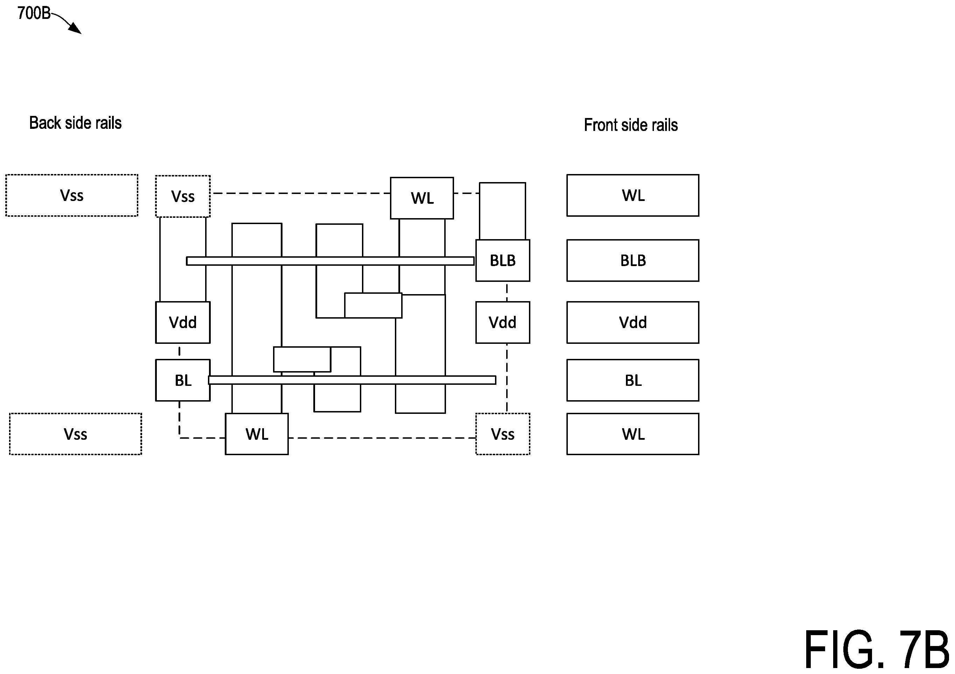

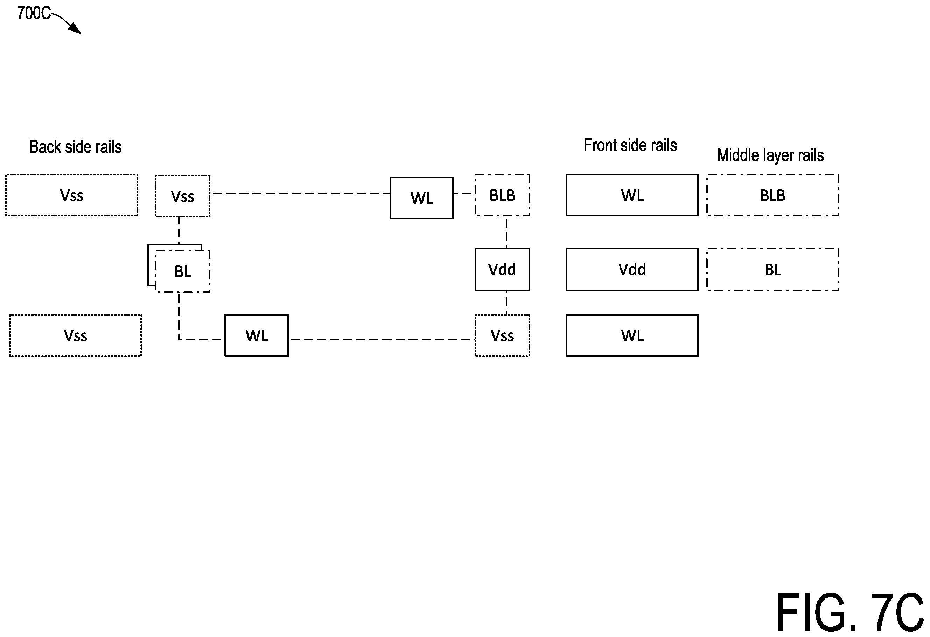

FIGS. 7A-7C illustrate example diagrams of memory cell designs implemented with different types of transistors. The view of the example designs is from above the memory cell (looking down in the z-direction as oriented in FIGS. 3A-3D). In particular, FIG. 7A illustrates a memory cell design 700A implemented with a non-CFET architecture, FIG. 7B illustrates a memory cell design 700B implemented with a CFET architecture with backside metallization and without middle layer routing as described herein, and FIG. 7C illustrates a memory cell design 700C implemented with a CFET architecture with backside metallization and also middle layer routing between stacked transistors as described herein.

As will be seen from the examples shown, embodiments of the present disclosure can allow for reduced area usage for the same memory cells by scaling in the z-direction. More particularly, the design 700A includes eight front side signal rails as shown, while a CFET design with stacked transistors allows for the certain signal rails (e.g., Vss in the example shown) to be included in backside routing, reducing the number of front side rails needed for the memory cell and accordingly reducing the x-y area needed for the cell. This is further shown with a CFET design having middle layer routing as described herein, as even more signal rails (e.g., BL and BLB) can be routed in the middle metallization layers between the stacked transistors of the CFET, allowing for further reduction in the front side rails needed and thus the x-y area required by the cell. This same area savings can also be seen with other integrated circuit designs (e.g., such as standard cells or other integrated circuit designs) implementing CFET architectures as described herein.

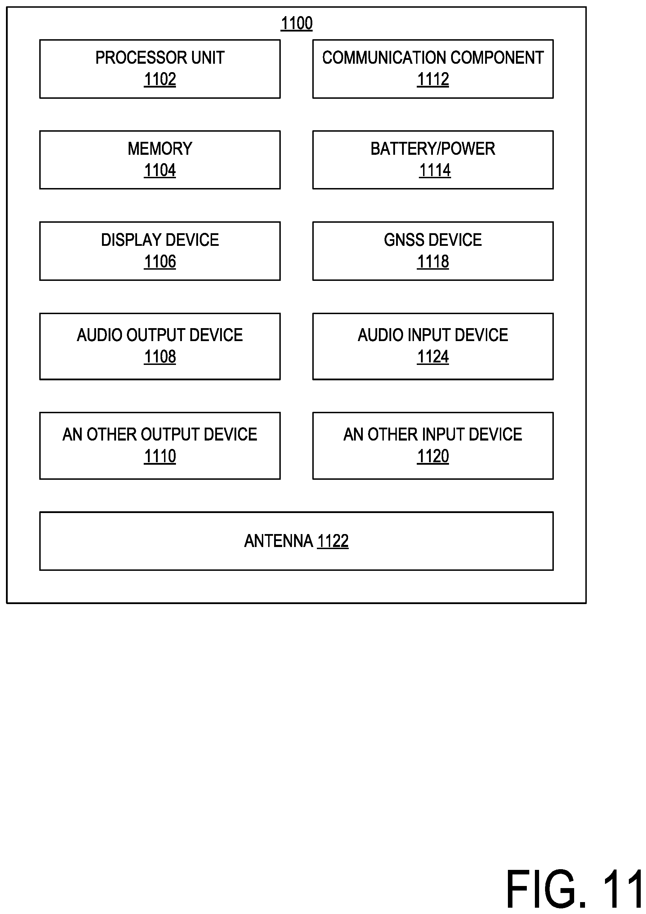

FIG. 8 is a top view of a wafer 800 and dies 802 that may incorporate any of the embodiments disclosed herein. The wafer 800 may be composed of semiconductor material and may include one or more dies 802 having integrated circuit structures formed on a surface of the wafer 800. The individual dies 802 may be a repeating unit of an integrated circuit product that includes any suitable integrated circuit. After the fabrication of the semiconductor product is complete, the wafer 800 may undergo a singulation process in which the dies 802 are separated from one another to provide discrete "chips" of the integrated circuit product. The die 802 may include one or more transistors (e.g., some of the transistors 940 of FIG. 9, discussed below), supporting circuitry to route electrical signals to the transistors, passive components (e.g., signal traces, resistors, capacitors, or inductors), and/or any other integrated circuit components. In some embodiments, the wafer 800 or the die 802 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 802. For example, a memory array formed by multiple memory devices may be formed on a same die 802 as a processor unit (e.g., the processor unit 1102 of FIG. 11) or other logic that is configured to store information in the memory devices or execute instructions stored in the memory array.

FIG. 9 is a cross-sectional side view of an integrated circuit device 900 that may be included in embodiments herein. One or more of the integrated circuit devices 900 may be included in one or more dies 802 (FIG. 8). The integrated circuit device 900 may be formed on a die substrate 902 (e.g., the wafer 800 of FIG. 8) and may be included in a die (e.g., the die 802 of FIG. 8). The die substrate 902 may be a semiconductor substrate composed of semiconductor material systems including, for example, n-type or p-type materials systems (or a combination of both). The die substrate 902 may include, for example, a crystalline substrate formed using a bulk silicon or a silicon-on-insulator (SOI) substructure. In some embodiments, the die substrate 902 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 902. Although a few examples of materials from which the die substrate 902 may be formed are described here, any material that may serve as a foundation for an integrated circuit device 900 may be used. The die substrate 902 may be part of a singulated die (e.g., the dies 802 of FIG. 8) or a wafer (e.g., the wafer 800 of FIG. 8).

The integrated circuit device 900 may include one or more device layers 904 disposed on the die substrate 902. The device layer 904 may include features of one or more transistors 940 (e.g., metal oxide semiconductor field-effect transistors (MOSFETs)) formed on the die substrate 902. The transistors 940 may include, for example, one or more source and/or drain (S/D) regions 920, a gate 922 to control current flow between the S/D regions 920, and one or more S/D contacts 924 to route electrical signals to/from the S/D regions 920. The transistors 940 may include additional features not depicted for the sake of clarity, such as device isolation regions, gate contacts, and the like. The transistors 940 are not limited to the type and configuration depicted in FIG. 9 and may include a wide variety of other types and configurations such as, for example, planar transistors, non-planar transistors, or a combination of both. Non- planar transistors may include FinFET transistors, such as double-gate transistors or tri-gate transistors, and wrap-around or all-around gate transistors, such as nanoribbon, nanosheet, or nanowire transistors.

A transistor 940 may include a gate 922 formed of at least two layers, a gate dielectric and a gate electrode. The gate dielectric may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor 940 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer.

For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 940 along the source-channel-drain direction, the gate electrode may consist of a U-shaped structure that includes a bottom portion substantially parallel to the surface of the die substrate 902 and two sidewall portions that are substantially perpendicular to the top surface of the die substrate 902. In other embodiments, at least one of the metal layers that form the gate electrode may simply be a planar layer that is substantially parallel to the top surface of the die substrate 902 and does not include sidewall portions substantially perpendicular to the top surface of the die substrate 902. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 920 may be formed within the die substrate 902 adjacent to the gate 922 of individual transistors 940. The S/D regions 920 may be formed using an implantation/diffusion process or an etching/deposition process, for example. In the former process, dopants such as boron, aluminum, antimony, phosphorous, or arsenic may be ion-implanted into the die substrate 902 to form the S/D regions 920. An annealing process that activates the dopants and causes them to diffuse farther into the die substrate 902 may follow the ion-implantation process. In the latter process, the die substrate 902 may first be etched to form recesses at the locations of the S/D regions 920. An epitaxial deposition process may then be carried out to fill the recesses with material that is used to fabricate the S/D regions 920. In some implementations, the S/D regions 920 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 920 may be formed using one or more alternate semiconductor materials such as germanium or a group III-V material or alloy. In further embodiments, one or more layers of metal and/or metal alloys may be used to form the S/D regions 920.

Electrical signals, such as power and/or input/output (I/O) signals, may be routed to and/or from the devices (e.g., transistors 940) of the device layer 904 through one or more interconnect layers disposed on the device layer 904 (illustrated in FIG. 9 as interconnect layers 906-910). For example, electrically conductive features of the device layer 904 (e.g., the gate 922 and the S/D contacts 924) may be electrically coupled with the interconnect structures 928 of the interconnect layers 906-910. The one or more interconnect layers 906-910 may form a metallization stack (also referred to as an "ILD stack") 919 of the integrated circuit device 900.

The interconnect structures 928 may be arranged within the interconnect layers 906-910 to route electrical signals according to a wide variety of designs; in particular, the arrangement is not limited to the particular configuration of interconnect structures 928 depicted in FIG. 9. Although a particular number of interconnect layers 906-910 is depicted in FIG. 9, embodiments of the present disclosure include integrated circuit devices having more or fewer interconnect layers than depicted.

In some embodiments, the interconnect structures 928 may include lines 928a and/or vias 928b filled with an electrically conductive material such as a metal. The lines 928a may be arranged to route electrical signals in a direction of a plane that is substantially parallel with a surface of the die substrate 902 upon which the device layer 904 is formed. For example, the lines 928a may route electrical signals in a direction in and out of the page and/or in a direction across the page from the perspective of FIG. 9. The vias 928b may be arranged to route electrical signals in a direction of a plane that is substantially perpendicular to the surface of the die substrate 902 upon which the device layer 904 is formed. In some embodiments, the vias 928b may electrically couple lines 928a of different interconnect layers 906-910 together.

The interconnect layers 906-910 may include a dielectric material 926 disposed between the interconnect structures 928, as shown in FIG. 9. In some embodiments, dielectric material 926 disposed between the interconnect structures 928 in different ones of the interconnect layers 906-910 may have different compositions; in other embodiments, the composition of the dielectric material 926 between different interconnect layers 906-910 may be the same. The device layer 904 may include a dielectric material 926 disposed between the transistors 940 and a bottom layer of the metallization stack as well. The dielectric material 926 included in the device layer 904 may have a different composition than the dielectric material 926 included in the interconnect layers 906-910; in other embodiments, the composition of the dielectric material 926 in the device layer 904 may be the same as a dielectric material 926 included in any one of the interconnect layers 906-910.

A first interconnect layer 906 (referred to as Metal 1 or "M1") may be formed directly on the device layer 904. In some embodiments, the first interconnect layer 906 may include lines 928a and/or vias 928b, as shown. The lines 928a of the first interconnect layer 906 may be coupled with contacts (e.g., the S/D contacts 924) of the device layer 904. The vias 928b of the first interconnect layer 906 may be coupled with the lines 928a of a second interconnect layer 908.

The second interconnect layer 908 (referred to as Metal 2 or "M2") may be formed directly on the first interconnect layer 906. In some embodiments, the second interconnect layer 908 may include via 928b to couple the lines 928 of the second interconnect layer 908 with the lines 928a of a third interconnect layer 910. Although the lines 928a and the vias 928b are structurally delineated with a line within individual interconnect layers for the sake of clarity, the lines 928a and the vias 928b may be structurally and/or materially contiguous (e.g., simultaneously filled during a dual-damascene process) in some embodiments.

The third interconnect layer 910 (referred to as Metal 3 or "M3") (and additional interconnect layers, as desired) may be formed in succession on the second interconnect layer 908 according to similar techniques and configurations described in connection with the second interconnect layer 908 or the first interconnect layer 906. In some embodiments, the interconnect layers that are "higher up" in the metallization stack 919 in the integrated circuit device 900 (i.e., farther away from the device layer 904) may be thicker that the interconnect layers that are lower in the metallization stack 919, with lines 928a and vias 928b in the higher interconnect layers being thicker than those in the lower interconnect layers.

The integrated circuit device 900 may include a solder resist material 934 (e.g., polyimide or similar material) and one or more conductive contacts 936 formed on the interconnect layers 906-910. In FIG. 9, the conductive contacts 936 are illustrated as taking the form of bond pads. The conductive contacts 936 may be electrically coupled with the interconnect structures 928 and configured to route the electrical signals of the transistor(s) 940 to external devices. For example, solder bonds may be formed on the one or more conductive contacts 936 to mechanically and/or electrically couple an integrated circuit die including the integrated circuit device 900 with another component (e.g., a printed circuit board). The integrated circuit device 900 may include additional or alternate structures to route the electrical signals from the interconnect layers 906-910; for example, the conductive contacts 936 may include other analogous features (e.g., posts) that route the electrical signals to external components.

In some embodiments in which the integrated circuit device 900 is a double-sided die, the integrated circuit device 900 may include another metallization stack (not shown) on the opposite side of the device layer(s) 904. This metallization stack may include multiple interconnect layers as discussed above with reference to the interconnect layers 906-910, to provide conductive pathways (e.g., including conductive lines and vias) between the device layer(s) 904 and additional conductive contacts (not shown) on the opposite side of the integrated circuit device 900 from the conductive contacts 936.

In other embodiments in which the integrated circuit device 900 is a double-sided die, the integrated circuit device 900 may include one or more through silicon vias (TSVs) through the die substrate 902; these TSVs may make contact with the device layer(s) 904, and may provide conductive pathways between the device layer(s) 904 and additional conductive contacts (not shown) on the opposite side of the integrated circuit device 900 from the conductive contacts 936. In some embodiments, TSVs extending through the substrate can be used for routing power and ground signals from conductive contacts on the opposite side of the integrated circuit device 900 from the conductive contacts 936 to the transistors 940 and any other components integrated into the die 900, and the metallization stack 919 can be used to route I/O signals from the conductive contacts 936 to transistors 940 and any other components integrated into the die 900.

Multiple integrated circuit devices 900 may be stacked with one or more TSVs in the individual stacked devices providing connection between one of the devices to any of the other devices in the stack. For example, one or more high-bandwidth memory (HBM) integrated circuit dies can be stacked on top of a base integrated circuit die and TSVs in the HBM dies can provide connection between the individual HBM and the base integrated circuit die. Conductive contacts can provide additional connections between adjacent integrated circuit dies in the stack. In some embodiments, the conductive contacts can be fine-pitch solder bumps (microbumps).

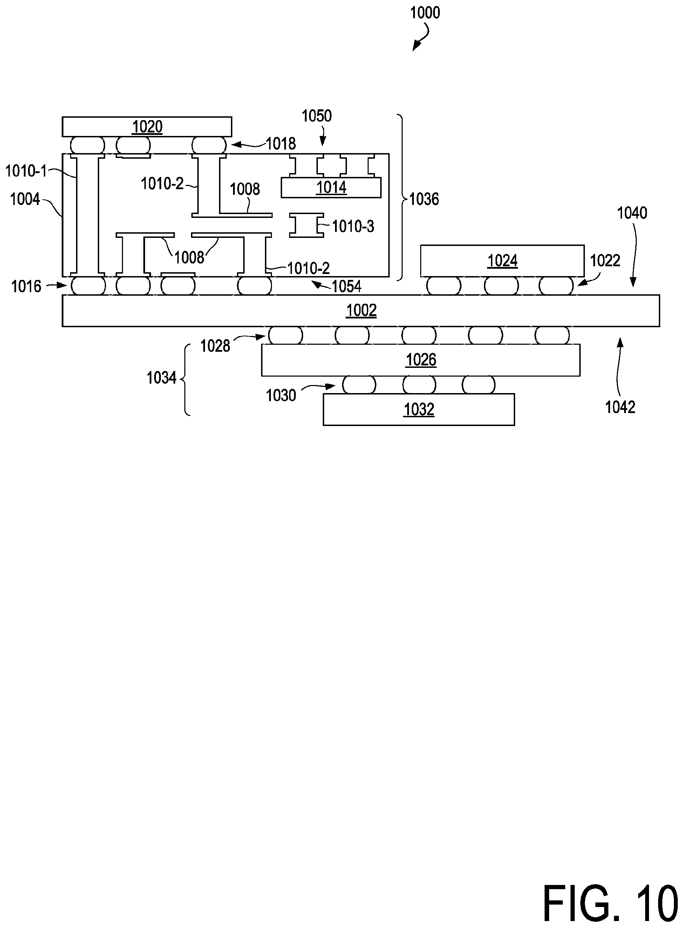

FIG. 10 is a cross-sectional side view of an integrated circuit device assembly 1000 that may include any of the embodiments disclosed herein. The integrated circuit device assembly 1000 includes a number of components disposed on a circuit board 1002 (which may be a motherboard, system board, mainboard, etc.). The integrated circuit device assembly 1000 includes components disposed on a first face 1040 of the circuit board 1002 and an opposing second face 1042 of the circuit board 1002; generally, components may be disposed on one or both faces 1040 and 1042.

In some embodiments, the circuit board 1002 may be a printed circuit board (PCB) including multiple metal (or interconnect) layers separated from one another by layers of dielectric material and interconnected by electrically conductive vias. The individual metal layers comprise conductive traces. Any one or more of the metal layers may be formed in a desired circuit pattern to route electrical signals (optionally in conjunction with other metal layers) between the components coupled to the circuit board 1002. In other embodiments, the circuit board 1002 may be a non-PCB substrate. The integrated circuit device assembly 1000 illustrated in FIG. 10 includes a package-on-interposer structure 1036 coupled to the first face 1040 of the circuit board 1002 by coupling components 1016. The coupling components 1016 may electrically and mechanically couple the package-on-interposer structure 1036 to the circuit board 1002, and may include solder balls (as shown in FIG. 10), pins (e.g., as part of a pin grid array (PGA), contacts (e.g., as part of a land grid array (LGA)), male and female portions of a socket, an adhesive, an underfill material, and/or any other suitable electrical and/or mechanical coupling structure.

The package-on-interposer structure 1036 may include an integrated circuit component 1020 coupled to an interposer 1004 by coupling components 1018. The coupling components 1018 may take any suitable form for the application, such as the forms discussed above with reference to the coupling components 1016. Although a single integrated circuit component 1020 is shown in FIG. 10, multiple integrated circuit components may be coupled to the interposer 1004; indeed, additional interposers may be coupled to the interposer 1004. The interposer 1004 may provide an intervening substrate used to bridge the circuit board 1002 and the integrated circuit component 1020.

The integrated circuit component 1020 may be a packaged or unpacked integrated circuit product that includes one or more integrated circuit dies (e.g., the die 802 of FIG. 8, the integrated circuit device 900 of FIG. 9) and/or one or more other suitable components. A packaged integrated circuit component comprises one or more integrated circuit dies mounted on a package substrate with the integrated circuit dies and package substrate encapsulated in a casing material, such as a metal, plastic, glass, or ceramic. In one example of an unpackaged integrated circuit component 1020, a single monolithic integrated circuit die comprises solder bumps attached to contacts on the die. The solder bumps allow the die to be directly attached to the interposer 1004. The integrated circuit component 1020 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the integrated circuit component 1020 can comprise one or more additional active or passive devices such as capacitors, decoupling capacitors, resistors, inductors, fuses, diodes, transformers, sensors, electrostatic discharge (ESD) devices, and memory devices.

In embodiments where the integrated circuit component 1020 comprises multiple integrated circuit dies, they dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 1020 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Generally, the interposer 1004 may spread connections to a wider pitch or reroute a connection to a different connection. For example, the interposer 1004 may couple the integrated circuit component 1020 to a set of ball grid array (BGA) conductive contacts of the coupling components 1016 for coupling to the circuit board 1002. In the embodiment illustrated in FIG. 10, the integrated circuit component 1020 and the circuit board 1002 are attached to opposing sides of the interposer 1004; in other embodiments, the integrated circuit component 1020 and the circuit board 1002 may be attached to a same side of the interposer 1004. In some embodiments, three or more components may be interconnected by way of the interposer 1004.

In some embodiments, the interposer 1004 may be formed as a PCB, including multiple metal layers separated from one another by layers of dielectric material and interconnected by electrically conductive vias. In some embodiments, the interposer 1004 may be formed of an epoxy resin, a fiberglass-reinforced epoxy resin, an epoxy resin with inorganic fillers, a ceramic material, or a polymer material such as polyimide. In some embodiments, the interposer 1004 may be formed of alternate rigid or flexible materials that may include the same materials described above for use in a semiconductor substrate, such as silicon, germanium, and other group III-V and group IV materials. The interposer 1004 may include metal interconnects 1008 and vias 1010, including but not limited to through hole vias 1010-1 (that extend from a first face 1050 of the interposer 1004 to a second face 1054 of the interposer 1004), blind vias 1010-2 (that extend from the first or second faces 1050 or 1054 of the interposer 1004 to an internal metal layer), and buried vias 1010-3 (that connect internal metal layers).

In some embodiments, the interposer 1004 can comprise a silicon interposer. Through silicon vias (TSV) extending through the silicon interposer can connect connections on a first face of a silicon interposer to an opposing second face of the silicon interposer. In some embodiments, an interposer 1004 comprising a silicon interposer can further comprise one or more routing layers to route connections on a first face of the interposer 1004 to an opposing second face of the interposer 1004.

The interposer 1004 may further include embedded devices 1014, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 1004. The package-on-interposer structure 1036 may take the form of any of the package-on-interposer structures known in the art. In embodiments where the interposer is a non-printed circuit board

The integrated circuit device assembly 1000 may include an integrated circuit component 1024 coupled to the first face 1040 of the circuit board 1002 by coupling components 1022. The coupling components 1022 may take the form of any of the embodiments discussed above with reference to the coupling components 1016, and the integrated circuit component 1024 may take the form of any of the embodiments discussed above with reference to the integrated circuit component 1020.

The integrated circuit device assembly 1000 illustrated in FIG. 10 includes a package-on-package structure 1034 coupled to the second face 1042 of the circuit board 1002 by coupling components 1028. The package-on-package structure 1034 may include an integrated circuit component 1026 and an integrated circuit component 1032 coupled together by coupling components 1030 such that the integrated circuit component 1026 is disposed between the circuit board 1002 and the integrated circuit component 1032. The coupling components 1028 and 1030 may take the form of any of the embodiments of the coupling components 1016 discussed above, and the integrated circuit components 1026 and 1032 may take the form of any of the embodiments of the integrated circuit component 1020 discussed above. The package-on-package structure 1034 may be configured in accordance with any of the package-on-package structures known in the art.

FIG. 11 is a block diagram of an example electrical device 1100 that may include one or more of the embodiments disclosed herein. For example, any suitable ones of the components of the electrical device 1100 may include one or more of the integrated circuit device assemblies 1000, integrated circuit components 1020, integrated circuit devices 900, or integrated circuit dies 802 disclosed herein. A number of components are illustrated in FIG. 11 as included in the electrical device 1100, but any one or more of these components may be omitted or duplicated, as suitable for the application. In some embodiments, some or all of the components included in the electrical device 1100 may be attached to one or more motherboards mainboards, or system boards. In some embodiments, one or more of these components are fabricated onto a single system-on-a-chip (SoC) die.

Additionally, in various embodiments, the electrical device 1100 may not include one or more of the components illustrated in FIG. 11, but the electrical device 1100 may include interface circuitry for coupling to the one or more components. For example, the electrical device 1100 may not include a display device 1106, but may include display device interface circuitry (e.g., a connector and driver circuitry) to which a display device 1106 may be coupled. In another set of examples, the electrical device 1100 may not include an audio input device 1124 or an audio output device 1108, but may include audio input or output device interface circuitry (e.g., connectors and supporting circuitry) to which an audio input device 1124 or audio output device 1108 may be coupled.

The electrical device 1100 may include one or more processor units 1102 (e.g., one or more processor units). As used herein, the terms "processor unit", "processing unit" or "processor" may refer to any device or portion of a device that processes electronic data from registers and/or memory to transform that electronic data into other electronic data that may be stored in registers and/or memory. The processor unit 1102 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 1100 may include a memory 1104, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 1104 may include memory that is located on the same integrated circuit die as the processor unit 1102. This memory may be used as cache memory (e.g., Level 1 (L1), Level 2 (L2), Level 3 (L3), Level 4 (L4), Last Level Cache (LLC)) and may include embedded dynamic random access memory (eDRAM) or spin transfer torque magnetic random access memory (STT-MRAM).

In some embodiments, the electrical device 1100 can comprise one or more processor units 1102 that are heterogeneous or asymmetric to another processor unit 1102 in the electrical device 1100. There can be a variety of differences between the processing units 1102 in a system in terms of a spectrum of metrics of merit including architectural, microarchitectural, thermal, power consumption characteristics, and the like. These differences can effectively manifest themselves as asymmetry and heterogeneity among the processor units 1102 in the electrical device 1100.

In some embodiments, the electrical device 1100 may include a communication component 1112 (e.g., one or more communication components). For example, the communication component 1112 can manage wireless communications for the transfer of data to and from the electrical device 1100. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 1112 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 1112 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 1112 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 1112 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 1112 may operate in accordance with other wireless protocols in other embodiments. The electrical device 1100 may include an antenna 1122 to facilitate wireless communications and/or to receive other wireless communications (such as AM or FM radio transmissions).

In some embodiments, the communication component 1112 may manage wired communications, such as electrical, optical, or any other suitable communication protocols (e.g., IEEE 802.3 Ethernet standards). As noted above, the communication component 1112 may include multiple communication components. For instance, a first communication component 1112 may be dedicated to shorter-range wireless communications such as Wi-Fi or Bluetooth, and a second communication component 1112 may be dedicated to longer-range wireless communications such as global positioning system (GPS), EDGE, GPRS, CDMA, WiMAX, LTE, EV-DO, or others. In some embodiments, a first communication component 1112 may be dedicated to wireless communications, and a second communication component 1112 may be dedicated to wired communications.

The electrical device 1100 may include battery/power supply circuitry 1114. The battery/power supply circuitry 1114 may include one or more energy storage devices (e.g., batteries or capacitors) and/or circuitry for coupling components of the electrical device 1100 to an energy source separate from the electrical device 1100 (e.g., AC line power).

The electrical device 1100 may include a display device 1106 (or corresponding interface circuitry, as discussed above). The display device 1106 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 1100 may include an audio output device 1108 (or corresponding interface circuitry, as discussed above). The audio output device 1108 may include any embedded or wired or wirelessly connected external device that generates an audible indicator, such speakers, headsets, or earbuds.

The electrical device 1100 may include an audio input device 1124 (or corresponding interface circuitry, as discussed above). The audio input device 1124 may include any embedded or wired or wirelessly connected device that generates a signal representative of a sound, such as microphones, microphone arrays, or digital instruments (e.g., instruments having a musical instrument digital interface (MIDI) output). The electrical device 1100 may include a Global Navigation Satellite System (GNSS) device 1118 (or corresponding interface circuitry, as discussed above), such as a Global Positioning System (GPS) device. The GNSS device 1118 may be in communication with a satellite-based system and may determine a geolocation of the electrical device 1100 based on information received from one or more GNSS satellites, as known in the art.

The electrical device 1100 may include another output device 1110 (or corresponding interface circuitry, as discussed above). Examples of the other output device 1110 may include an audio codec, a video codec, a printer, a wired or wireless transmitter for providing information to other devices, or an additional storage device.

The electrical device 1100 may include another input device 1120 (or corresponding interface circuitry, as discussed above). Examples of the other input device 1120 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 1100 may have any desired form factor, such as a hand-held or mobile electrical device (e.g., a cell phone, a smart phone, a mobile internet device, a music player, a tablet computer, a laptop computer, a 2-in-1 convertible computer, a portable all-in-one computer, a netbook computer, an ultrabook computer, a personal digital assistant (PDA), an ultra mobile personal computer, a portable gaming console, etc.), a desktop electrical device, a server, a rack-level computing solution (e.g., blade, tray or sled computing systems), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 1100 may be any other electronic device that processes data. In some embodiments, the electrical device 1100 may comprise multiple discrete physical components. Given the range of devices that the electrical device 1100 can be manifested as in various embodiments, in some embodiments, the electrical device 1100 can be referred to as a computing device or a computing system.

Illustrative examples of the technologies described throughout this disclosure are provided below. Embodiments of these technologies may include any one or more, and any combination of, the examples described below. In some embodiments, at least one of the systems or components set forth in one or more of the preceding figures may be configured to perform one or more operations, techniques, processes, and/or methods as set forth in the following examples.

Example 1 is an apparatus comprising: an integrated circuit device comprising: a first transistor; a second transistor above the first transistor; a metallization layer between the first transistor and the second transistor; and a plurality of metallization layers below the second transistor.

Example 2 includes the subject matter of Example 1, wherein the metallization layer between the first transistor and the second transistor is a first metallization layer, and the apparatus further comprises a second metallization layer between the first transistor and the second transistor.

Example 3 includes the subject matter of Example 1 or 2, wherein the first transistor and the second transistor are FinFET transistors.

Example 4 includes the subject matter of Example 1 or 2, wherein the first transistor and the second transistor are Gate All Around (GAA) transistors.

Example 4.5 includes the subject matter of Example 1 or 2, wherein the first transistor and the second transistor are planar transistors.

Example 5 includes the subject matter of any one of Examples 1-4, further comprising a plurality of metallization layers above the first transistor.

Example 6 includes the subject matter of any one of Examples 1-5, further comprising air between the first transistor and the second transistor.

Example 7 includes the subject matter of any one of Examples 1-6, further comprising a package substrate, the integrated circuit device coupled to the package substrate.

Example 8 includes the subject matter of Example 7, further comprising a circuit board, the package substrate coupled to the circuit board.

Example 9 includes the subject matter of any one of Examples 1-8, wherein the integrated circuit device comprises a processor or memory.

Example 10 is a method comprising: forming first transistors on a first wafer; forming one or more metallization layers above the first transistors on the first wafer; forming semiconductor channels for second transistors on a second wafer; bonding the second wafer to the first wafer, wherein the semiconductor channels for each of the second transistors are above a respective first transistor; forming source/drain regions and a gate region for each of the second transistors; and forming a plurality of metallization layers above the second transistors.

Example 11 includes the subject matter of Example 10, further comprising forming one or more metallization layers below the first transistors on the first wafer.

Example 12 includes the subject matter of Example 10 or 11, further comprising flipping (e.g., rotating approximately 180 degrees) the second wafer before bonding the second wafer to the first wafer.

Example 13 includes the subject matter of any one of Examples 10-12, wherein the first transistors and the second transistors are FinFET transistors.

Example 14 includes the subject matter of any one of Examples 10-12, wherein the first transistors and the second transistors are Gate All Around (GAA) transistors.

Example 14.5 includes the subject matter of any one of Examples 10-12, wherein the first transistors and the second transistors are planar transistors.

Example 15 is a method comprising: forming first transistors on a first wafer; forming one or more metallization layers above the first transistors on the first wafer; forming second transistors on a second wafer; bonding the second wafer to the first wafer, wherein each second transistor is above a respective first transistor; and forming a plurality of metallization layers above the second transistors.

Example 16 includes the subject matter of Example 15, further comprising forming one or more metallization layers above the second transistors on the second wafer before bonding the second wafer to the first wafer.

Example 17 includes the subject matter of Example 15 or 16, further comprising forming one or more metallization layers below the first transistors on the first wafer.

Example 18 includes the subject matter of any one of Examples 15-17, further comprising flipping (e.g., rotating approximately 180 degrees) the second wafer before bonding the second wafer to the first wafer.

Example 19 includes the subject matter of any one of Examples 15-18, wherein the first transistors and the second transistors are FinFET transistors.

Example 20 includes the subject matter of any one of Examples 15-19, wherein the first transistors and the second transistors are Gate All Around (GAA) transistors.

Example 21 includes the subject matter of any one of Examples 15-19, wherein the first transistors and the second transistors are planar transistors.

In the above description, various aspects of the illustrative implementations have been described using terms commonly employed by those skilled in the art to convey the substance of their work to others skilled in the art. However, it will be apparent to those skilled in the art that the present disclosure may be practiced with only some of the described aspects. For purposes of explanation, specific numbers, materials, and configurations have been set forth to provide a thorough understanding of the illustrative implementations. However, it will be apparent to one skilled in the art that the present disclosure may be practiced without all of the specific details. In other instances, well-known features have been omitted or simplified in order not to obscure the illustrative implementations.

Further, concepts described herein are illustrated by way of example and not by way of limitation in the accompanying figures. For simplicity and clarity of illustration, elements illustrated in the figures might not be necessarily drawn to scale. Where considered appropriate, reference labels may have been repeated between certain Figures to indicate corresponding or analogous elements.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B and C).

The terms "over," "under," "between," "above," and "on" as used herein may refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening features.

The above description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

The term "coupled with," along with its derivatives, may be used herein. "Coupled" may mean one or more of the following. "Coupled" may mean that two or more elements are in direct physical or electrical contact. However, "coupled" may also mean that two or more elements indirectly contact each other, but yet still cooperate or interact with each other, and may mean that one or more other elements are coupled or connected between the elements that are said to be coupled with each other. The term "directly coupled" may mean that two or more elements are in direct contact.

In various embodiments, the phrase "a first feature formed, deposited, or otherwise disposed on a second feature" may mean that the first feature is formed, deposited, or disposed over the second feature, and at least a part of the first feature may be in direct contact (e.g., direct physical and/or electrical contact) or indirect contact (e.g., having one or more other features between the first feature and the second feature) with at least a part of the second feature.

In various embodiments, the phrase "located on" in the context of a first layer or component located on a second layer or component refers to the first layer or component being directly physically attached to the second part or component (no layers or components between the first and second layers or components) or physically attached to the second layer or component with one or more intervening layers or components.

In various embodiments, the term "adjacent" refers to layers or components that are in physical contact with each other. That is, there is no layer or component between the stated adjacent layers or components. For example, a layer X that is adjacent to a layer Y refers to a layer that is in physical contact with layer Y.

Where the disclosure recites "a" or "a first" element or the equivalent thereof, such disclosure includes one or more such elements, neither requiring nor excluding two or more such elements. Further, ordinal indicators (e.g., first, second, or third) for identified elements are used to distinguish between the elements, and do not indicate or imply a required or limited number of such elements, nor do they indicate a particular position or order of such elements unless otherwise specifically stated.

## Claims

1. An apparatus comprising:
an integrated circuit device comprising:
a first transistor;
a second transistor above the first transistor;
a metallization layer between the first transistor and the second transistor; and
a plurality of metallization layers below the second transistor.

2. The apparatus of claim 1, wherein the metallization layer between the first transistor and the second transistor is a first metallization layer, and the apparatus further comprises a second metallization layer between the first transistor and the second transistor.

3. The apparatus of claim 1 or 2, wherein the first transistor and the second transistor are FinFET transistors.

4. The apparatus of claim 1 or 2, wherein the first transistor and the second transistor are Gate All Around (GAA) transistors.

5. The apparatus of any one of claims 1-4, further comprising a plurality of metallization layers above the first transistor.

6. The apparatus of any one of claims 1-5, further comprising air between the first transistor and the second transistor.

7. The apparatus of any one of claims 1-6, further comprising a package substrate, the integrated circuit device coupled to the package substrate.

8. A system comprising:
a circuit board;
a package substrate coupled to the circuit board; and
an integrated circuit device coupled to the package substrate, the integrated circuit device comprising the apparatus of any one of claims 1-6.

9. The system of claim 8, wherein the integrated circuit device comprises a processor or memory.

10. The system of claim 8 or 9, further comprising power supply circuitry coupled to the circuit board.

11. A method comprising:
forming first transistors on a first wafer;
forming one or more metallization layers above the first transistors on the first wafer;
forming semiconductor channels for second transistors on a second wafer;
bonding the second wafer to the first wafer, wherein the semiconductor channels for each of the second transistors are above a respective first transistor;
forming source/drain regions and a gate region for each of the second transistors; and
forming a plurality of metallization layers above the second transistors.

12. The method of claim 11, further comprising forming one or more metallization layers below the first transistors on the first wafer.

13. The method of claim 11 or 12, further comprising flipping the second wafer before bonding the second wafer to the first wafer.

14. The method of any one of claims 11-13, wherein the first transistors and the second transistors are FinFET transistors.

15. The method of any one of claims 11-13, wherein the first transistors and the second transistors are Gate All Around (GAA) transistors.
